# EUROPÄISCHE PATENTSCHRIFT

(11) **EP 2 745 660 B1**
(45) Veröffentlichungstag und Bekanntmachung des Hinweises auf die Patenterteilung: **19.08.2015**
(21) Anmeldenummer: 12743120.3
(22) Anmeldetag: 24.07.2012
(51) Int. Cl.: H05K 5/00, H05K 5/06

(54) **GEHÄUSEELEMENT FÜR EIN STEUERGERÄTEGEHÄUSE**
HOUSING ELEMENT FOR A CONTROL DEVICE HOUSING
ÉLÉMENT DE BOÎTIER POUR UN BOÎTIER D'APPAREIL DE COMMANDE

(30) Priorität: 16.08.2011 DE 102011080988
(43) Veröffentlichungstag der Anmeldung: 25.06.2014
(73) Patentinhaber: ZF Friedrichshafen AG, 88038 Friedrichshafen (DE)
(72) Erfinder: BECK, Werner, 92224 Amberg (DE)
(86) Internationale Anmeldenummer: PCT/EP2012/064480
(87) Internationale Veröffentlichungsnummer: WO 2013/023881

(56) Entgegenhaltungen:
- WO-A1-2011/029714
- DE-A1-102007 015 938
- DE-C1- 3 639 440
- JP-A- 2002 271 064

## Beschreibung

Die vorliegende Erfindung betrifft ein Gehäuseelement für ein Steuergerätegehäuse gemäß dem Oberbegriff des Patentanspruchs 1, insbesondere ein Gehäuseelement für ein in einem Kraftfahrzeug verwendbares Steuergerätegehäuse.

Üblicherweise beherbergt ein Steuergerätegehäuse elektronische Komponenten beispielsweise einer elektronischen Schaltung oder Steuerung und schützt diese gegen Umwelteinflüsse und/oder mechanische Beanspruchung. Dazu weist ein Steuergerätegehäuse wenigstens zwei miteinander verbindbare Gehäuseelemente auf, die im verbundenen Zustand einen Gehäuseinnenraum zur Aufnahme der elektronischen Komponenten ausbilden können. Die Gehäuseelemente werden im Allgemeinen in einem den Gehäuseinnenraum einfassenden Randbereich unter Zwischenlage eines Dichtmittels miteinander verbunden, um so den Gehäuseinnenraum gegenüber der Gehäuseaußenseite abzudichten. Das Dichtmittel kann beispielsweise ein auf wenigstens einer Silikonkomponente basierendes Dichtmittel sein, welches unter Einfluss der in der Umgebungsluft enthaltenen Luftfeuchtigkeit aushärten kann. Der Randbereich der Gehäuseelemente kann auf verschiedene Art und Weise miteinander verbunden werden. So finden beispielsweise kraftschlüssige Verbindungen wie Schraubverbindungen, formschlüssige Verbindungen wie Hintergreifungen des einen Randbereichs an dem anderen Randbereich oder stoffschlüssige Verbindungen wie Klebeverbindungen Verwendung. Problematisch bei Verwendung des mittels Luftfeuchtigkeit aushärtenden Dichtmittels in dem Gehäuse ist eine vollständige Aushärtung des Dichtmittels in einem verbundenen Zustand der das Gehäuse ausbildenden Gehäuseelemente.

Die DE 195 05 125 A1 offenbart ein Gehäuse für ein Kfz-Steuergerät, wobei das Gehäuse zwei Gehäuseelemente umfasst, die im Randbereich unter Zwischenlage eines Dichtmittels mittels einer hintergreifenden formschlüssigen Verbindung miteinander verbunden werden.

Die DE 103 49 573 A1 zeigt ein Gehäuse für eine in einem Kraftfahrzeug verwendete elektronische Schaltung, wobei das Gehäuse zwei Gehäuseelemente umfasst, die im Randbereich unter Zwischenlage eines flüssigen, bei Zimmertemperatur aushärtenden Silikongummis mittels einer Schraubverbindung miteinander verbunden werden.

DE10 2007 015 938 D1 offenbart eine Anordnung für den Einbau von Elektronikbauteilen, wobei die Dichtigkeit des Gehäuses durch einen Ein-Komponenten-Polyurethanschaum oder einen Ein-Komponenten-Silikonelastomerschaum gesichert ist.

DE 36 39 440 D2 offenbart eine Anordnung zur Befestigung einer Tastaturmatte. Hierbei ist eine Silikon-Gussmasse in einer Zwischenlage angeordnet. Eine große Oberfläche der Matte, welche in Kontakt mit der Umgebung steht begünstigt hierbei die Verhärtung der Dichtung.

JP 2002 271064 offenbart ein Gehäuse für elektronische Bauteile. Die Gehäuseteile sind durch Crimpen zusammengesetzt, wobei ein Randabschnitt eine Aussparung aufweist. Ein weiteres Beispiel eines Gehäuses für elektronische Bauteile zeigt WO 2011/029714

Mit dem gemäß dem Patentanspruch 1 vorgeschlagenem Gehäuseelement kann eine ausreichende Aushärtung eines mittels Luftfeuchtigkeit aushärtbaren Dichtmittels in einem verbundenen Zustand der Gehäuseelemente gewährleistet werden. Ein solches Dichtmittel ist vorzugsweise ein auf Silikon basierendes Dichtmittel, das weiterhin bevorzugt bei Umgebungstemperatur aushärtet. Zur Aushärtung des Dichtmittels reicht der in vorzugsweise einer Umgebungsluft enthaltende Luftfeuchtigkeitsanteil aus. Eine ständige Kontaktierung des Dichtmittels mit der die Luftfeuchtigkeit enthaltenden Umgebungsluft bzw. eine alternativ bevorzugte Zuführung einer die Luftfeuchtigkeit enthaltenden Gases zu dem Dichtmittel wird über die Aussparung erreicht, wodurch die vollständige Aushärtung des Dichtmittels im verbundenen Zustand der Gehäuseelemente gewährleistet werden kann.

Eine Aussparung im Sinne der vorliegenden Erfindung ist ein Durchlass, der wenigstens zwei in verschiedene Richtungen zeigende Oberflächenseiten des Gehäuseelementes miteinander verbindet. Vorzugsweise ist das Gehäuseelement in dem Randabschnitt mit einer vorbestimmt definierten Wandstärke flach oder gekrümmt ausgestaltet, wobei die Aussparung von einer in eine erste Richtung zeigende erste Oberflächenseite zu einer in eine entgegengesetzte zweite Richtung zeigende zweite Oberflächenseite des Gehäuseelementes reicht.

Ferner bildet der Randabschnitt wenigstens einen Teilabschnitt eines das Gehäuseelement vollumfänglich begrenzenden Randes bzw. Randaußenkante aus. Der Randabschnitt weist vorzugsweise eine derartige Dimension auf, dass der Randabschnitt in Umfangsrichtung des Gehäuseelementes wenigstens eine Teillänge des Randes ausmacht und in einer parallel von der Randaußenkante bis zu einer Mitte des Gehäuseelementes verlaufenden Richtung einer sich von der Randaußenkante zu einem Gehäuseinneren nahen Ende einer zur Anlage mit dem zweiten Randabschnitt des zweiten Gehäuseelementes vorgesehenen Anlagefläche erstreckende Länge hat. Der Rand kann vorzugsweise einen das Gehäuseelement wenigstens abschnittsweisen oder vollumfänglich umlaufenden Kragen ausbilden.

Das Gehäuseelement kann einen oder mehr Randabschnitte umfassen, wobei bei gerader Anzahl an Randabschnitten, diese vorzugsweise auf sich gegenüberliegenden Randseiten des Gehäuseelementes angeordnet sind. Weiterhin bevorzugt kann das Gehäuseelement mehrere über den Rand des Gehäuseelementes verteilte Randabschnitte umfassen, die in Umlaufrichtung des Randes zueinander gleichbeabstandet angeordnet sind. Jegliche denkbare Anordnung von einer Mehrzahl an Randabschnitten mit zueinander gleichen, unterschiedlichen oder einer Kombination aus gleichen und unterschiedlichen Abständen ist denkbar. Vorzugsweise wird eine Anzahl an Randabschnitte und deren Anordnung über den vollumfänglichen Rand derart gewählt, dass das Dichtmittel über seiner vollständigen Erstreckungslänge mittels der in dem jeweiligen Randabschnitt ausgeformten Aussparung gleichmäßig aushärtbar ist. Beispielsweise kann der Rand in einer Draufsicht vorzugsweise ein rechteckiges, weiter bevorzugt ein viereckiges Gehäuseelement ausformen, wobei gegenüberliegende Randseiten oder alternativ jede Randseite wenigstens einen Randabschnitt mit wenigstens einer Aussparung umfasst. Weiter bevorzugt erstreckt sich der Randabschnitt entlang einer Randseite derart, dass ein oder mehrere Eckpunkte des rechteckigen Gehäuseelementes von dem Randabschnitt ausgespart bleiben. In diesen Eckpunkten können beispielsweise frei zugängliche Bohrungen zur Befestigung des Gehäuseelementes bzw. des mit dem Gehäuseelement ausgeformten Gehäuses an seinem Verwendungsort wie beispielsweise ein Kfz-Motorraum oder ein Kfz-Getriebe vorgesehen werden können.

Weiterhin bevorzugt kann der Randabschnitt mehr als eine Aussparung aufweisen, die weiter bevorzugt zueinander gleichbeabstandet und/oder mit einer identischen Ausgestaltung entlang des Randabschnittes angeordnet sein können. Damit kann die gleichmäßige Aushärtung des Dichtmittels weiter verbessert werden. Alternativ kann der Randabschnitt eine annähernd über die vollständige Erstreckungslänge des Randabschnittes ausgebildete Aussparung aufweisen.

Weitere bevorzugte Ausführungsformen des Gehäuseelementes sind mit den Unteransprüchen angegeben.

Gemäß einer bevorzugten Ausführungsform mit den Merkmalen nach dem Patentanspruch 2 kann das Dichtmittel vor Beschädigung geschützt werden. Obwohl eine Ausbildung der Aussparung in einem das Dichtmittel teilweise überlappenden oder unmittelbar angrenzenden Bereich denkbar wäre, können beispielsweise das Gehäuseelement umfassende Steuergerätegehäuse in einem Kfz an Orten vorgesehen werden, die einer möglichen direkten Beaufschlagung von Fremdmedien wie beispielsweise einem Hochdruckwasserstrahl oder Steinschlag unterliegen können. Durch die Anordnung der Aussparung in einem von dem Dichtmittel entfernten Bereich kann eine solche das Dichtmittel schädigende unmittelbare Beaufschlagung vermieden werden. Die Zufuhr der zur Aushärtung des Dichtmittels notwendigen Luftfeuchtigkeit kann über fertigungstoleranzbedingte Abstände zwischen den in dem Bereich zwischen der Aussparung und dem Dichtmittel vorgesehenen Anlageflächen der jeweiligen das Gehäuse ausbildenden Gehäuseelemente erfolgen. Vorzugsweise erfolgt die Zufuhr der Luftfeuchtigkeit über einen Zufuhrkanal, der weiter bevorzugt angrenzend zu der Aussparung und zu einem Bereich, in dem das Dichtmittel vorgesehen ist, angeordnet ist. Der Zufuhrkanal kann vorzugsweise in dem Randabschnitt des Gehäuseelementes ausgebildet sein. Alternativ kann der Zufuhrkanal vorzugsweise in dem zweiten Randabschnitt des zweiten Gehäuseelementes vorgesehen sein. Weiter alternativ können die zur gegenseitigen Anlage vorgesehenen Randabschnitte der Gehäuseelemente vorzugsweise jeweils einen Zufuhrkanalabschnitt aufweisen, welche in dem verbundenen Zustand der Gehäuseelemente den Zufuhrkanal ausbilden. Im Allgemeinen ist unter einem Zufuhrkanal ein zwischen dem ersten und zweiten Randabschnitt geschaffener Zwischenraum zu verstehen, über welchen die Luftfeuchtigkeit dem Dichtmittel zuführbar ist. Solch ein Luftzufuhrkanal kann beispielsweise auf einfache Art und Weise durch eine in dem Randabschnitt-Anlagebereich des Gehäuseelementes ein Oberflächenmaterial vorbestimmt abtragende Maßnahme erreicht werden.

Der Bereich zur Anlage mit oder zur Aufnahme des Dichtmittels ist vorzugsweise eine den Gehäuseinnenraum umlaufende Nut, die in dem ersten und/oder zweiten Randabschnitt ausformbar ist. Der Zufuhrkanal erstreckt sich in dieser bevorzugten Ausführungsform von der wenigstens einen Aussparung bis zu der Nut. Über den Zufuhrkanal kann weiter bevorzugt das mittels Luftfeuchtigkeit aushärtbare Dichtmittel in flüssiger Form der Nut zugeführt werden. Weitere Zuführkanäle für die Zuführung des Dichtmittels in die Nut bzw. zu dem Dichtmittelanlage- oder in den Dichtmittelaufnahmebereich können mit dem Gehäuseelement und/oder dem zweiten Gehäuseelement bereitgestellt werden.

Zusätzlich kann eines der Gehäuseelemente in einem der Nut gegenüberliegenden Bereich eine Erhebung ausformen, die im zusammengesetzten Zustand des Gehäuses in das zugeführte Dichtmittel hineinragt. Damit kann eine zwischen den Gehäuseelementen ausgeformte Dichtfläche vergrößert und/oder ein nach teilweise Aushärtung des Dichtmittels und anschließendem Verbinden der Gehäuseelemente das Dichtmittel beaufschlagender Druck erhöht werden, wodurch sich die Abdichtfunktion jeweils weiter verbessern lässt.

Nach einer bevorzugten Ausführungsform mit den Merkmalen des Patentanspruchs 3 wird eine kostengünstige und einfache Lösung zur gegenseitigen Befestigung der das Gehäuse ausbildenden Gehäuseelemente bereitgestellt. Dadurch können Befestigungsmittel wie Schrauben oder Verrastungen entfallen.

In dieser bevorzugten Ausführungsform ist der Randabschnitt biegbar ausgeformt. Das Gehäuseelement ist hierzu vorzugsweise wenigstens in dem den Randabschnitt aufweisenden Randbereich aus einem Metall ausgeformt, welches sich weiter bevorzugt wiederholbar verformen bzw. biegen lässt, ohne an der Biegestelle einem Biegebruch zu unterliegen. Weiterhin bevorzugt kann das Gehäuseelement vollständig aus einem Metall wie beispielsweise Aluminium ausgeformt sein, um eine Wärmesenke für die in dem Gehäuse aufnehmbaren elektronischen Komponenten bereitzustellen. Über das Gehäuseelement kann auf diese übliche Art und Weise die von den elektronischen Komponenten produzierte Wärme abgeführt werden.

Weiterhin ist in dieser bevorzugten Ausführungsform der Randabschnitt U-förmig zum klemmenden Einfassen des zweiten Randabschnittes biegbar. Unter einer U-Form ist im Sinne der vorliegenden Erfindung auch eine C-Form, eine W-Form oder jede andere Form zu verstehen, mittels welcher der zweite Randabschnitt klemmend einfassbar ist. Mit anderen Worten ist der erste Randabschnitt vorzugsweise derart biegbar, dass auf in entgegengesetzte Richtungen weisenden Oberflächenseiten des zweiten Randabschnittes eine Druckbeaufschlagung mittels des biegbaren Randabschnittes erzielbar ist. Vorzugsweise kann der erste Randabschnitt an wenigstens einer der Oberflächenseiten des zweiten Randabschnitts unmittelbar zur Anlage bringbar vorgesehen sein.

Gemäß einer weiter bevorzugten Ausführungsform mit den Merkmalen des Patentanspruchs 4 kann die Aussparung vorzugsweise einem stirnseitigen Ende des zweiten Randabschnittes gegenüberliegend angeordnet werden. Ein direkter Weg zwischen der Aussparung und dem Dichtmittel im verbundenen Zustand der Gehäuseelemente verläuft vorzugsweise L-förmig. Damit kann zuverlässig ein auf das Dichtmittel beispielsweise über den Hochdruckwasserstrahl wirkender Druck um ein erhebliches Maß reduziert werden, womit einer Beschädigung des Dichtmittels weiter vorteilhaft begegnet werden kann. Dieser Effekt kann bei bevorzugter Ausgestaltung eines Zufuhrkanals dadurch erhalten bleiben, dass die Aussparung in einem dem Zufuhrkanalfreien Bereich des zweiten Gehäuseelementes gegenüberliegend vorgesehen wird. Damit wird eine Überlappung des Zufuhrkanals mit der Aussparung vermieden, da die Überlappung die Gefahr birgt, dass der beispielsweise auf die Aussparung treffende Hochdruckwasserstrahl das Dichtmittel über den Zufuhrkanal unmittelbar mit einem Druck beaufschlagen kann, der zu einer Beschädigung des Dichtmittels führen könnte.

Abhängig von der Verwendung eines das Gehäuseelement umfassendes Steuergerätegehäuses kann die Aussparung alternativ in einem einen Schenkel des U-förmig biegbaren Randabschnitts definierenden Bereichs des ersten Randabschnitts angeordnet sein. Sofern die Aussparung in dem einen Schenkel ausformenden Bereich angeordnet wird, der dem Dichtmittel im verbundenen Zustand der Gehäuseelemente am Entferntesten liegt, ist ein von der Aussparung zu dem Dichtmittel führender Zufuhrkanal vorteilhaft, um einer Verlangsamung des Aushärtens des Dichtmittels im Vergleich zu einer dem Dichtmittel näheren Anordnung der Aussparung entgegenzuwirken.

Nach einer bevorzugten Ausführungsform mit den Merkmalen des Patentanspruchs 5 kann zwischen dem ersten und zweiten Randabschnitt ein mit der Aussparung kommunizierender Zwischenraum zur Bereitstellung eines dem Dichtmittel nahen Luft- oder Gasvolumens mit einem zur Aushärtung des Dichtmittels ausreichenden Luftfeuchtigkeitsanteil geschaffen werden. Wenn auch eine unmittelbare Anlage der Aussparung an dem zweiten Randabschnitt, vorzugsweise an dem stirnseitigen Ende des zweiten Randabschnitts denkbar ist, so kann die Zufuhr der Luftfeuchtigkeit zu dem Dichtmittel nur über die toleranzbedingten Spalte zwischen den Anlageflächen der ersten und zweiten Randabschnitte erfolgen, wobei das zu dem Dichtmittel zuführbare Gasvolumen und damit der zuführbaren Luftfeuchtigkeitsmenge abhängig von der Größe der toleranzbedingten Spalte und der Weglänge von der Aussparung zu dem Dichtmittelanlage- bzw. Dichtmittelaufnahmebereich ist. Mit dem Zwischenraum kann die Weglänge reduziert werden, wodurch ein Austausch der verbrauchten Luft bzw. dem verbrauchten Gas, welches seinen Luftfeuchtigkeitsanteil an das Dichtmittel zur Aushärtung abgegeben hat, mit neuer Luft/Gas durch den um das Gehäuseelement vorherrschenden Umgebungsdruck schneller erfolgen kann. Der Zwischenraum ist beispielsweise über den Zufuhrkanal ausbildbar, welcher sich vorzugsweise wenigstens in einen den Teilbereich der Aussparung überlappenden Bereich erstreckt. Je nach Einsatzort des das Gehäuseelement umfassende Gehäuses kann eine solche Ausführungsform vorteilhaft einsetzbar sein.

Alternativ dazu kann der Zwischenraum gemäß der weiter bevorzugten Ausführungsform mit den Merkmalen nach dem Patentanspruch 6 ausgeformt werden. In dieser weiter bevorzugten Ausführungsform kann die U-Form des biegbaren Randabschnittes auf einfache Art und Weise erreicht werden, indem der erste Randabschnitt ausgehend von oder über eine L-Form in eine U-Form gebogen wird, wobei der Grund der U-Form automatisch einen von dem Gehäuseelement wegweisenden, einen Radius definierenden Bogen ausformt, in welchem die Aussparung angeordnet ist. Alternativ kann der biegbare Randabschnitt ausgehend von oder über die L-Form in eine W-Form gebogen werden, wobei der einen Grund der W-Form ausmachende Randmittelabschnitt eine über drei aufeinander folgende Radien definierte Wellenform einnimmt. Die Wellenform umfasst zwei von dem Gehäuseelement wegweisende, durch einen Radius ausgebildete äußere Bögen und einen zu den äußeren Bögen entgegengesetzt gerichteten durch einen Radius ausgebildeten mittleren Bogen. Die Radien können zueinander vorzugsweise identisch und/oder unterschiedlich sein. Mit dieser bevorzugten Ausführungsform kann über den mittleren Bogen ein Anschlag für das zweite Gehäuseelement bereitgestellt werden. Dadurch kann im verbundenen Zustand der Gehäuseelemente eine relative Verschiebung der Gehäuseelemente untereinander verhindert werden.

Die wenigstens eine Aussparung ist in dieser bevorzugten Ausführungsform wenigstens in einem dem Dichtmittel nahen Bogenbereich der Wellenform angeordnet, wobei sich die Aussparung vorzugsweise zwischen dem den Anschlag ausformenden mittleren Bogen und dem benachbarten, dem Dichtmittel nahe liegenden äußeren Bogen erstreckt. Alternativ kann die wenigstens eine Aussparung von einem die Wellenform ausbildenden Bereichs des Randmittelabschnitts eingefasst sein und sich über den vollständigen Bereich der Wellenform erstrecken. Mit anderen Worten kann die Aussparung vorzugsweise benachbart zu einem Materialbereich des Randmittelabschnitts angeordnet sein, der die Wellenform ausbildet, wobei sich die Aussparung zwischen den beiden äußeren Schenkeln des W-förmig ausgebildeten ersten Randabschnitts von dem einen äußeren Bogen bis zu dem anderen äußeren Bogen erstrecken kann.

Gemäß einem weiteren Aspekt der vorliegenden Erfindung wird ein Gehäuse für ein Steuergerät, insbesondere für ein Kfz-Steuergerät mit den Merkmalen nach dem Patentanspruch 7, vorzugsweise mit den Merkmalen nach einem der Patentansprüche 8 bis 10 vorgeschlagen. Dadurch lassen sich die in Verbindung mit den bevorzugten Ausführungsformen eines Gehäuseelementes nach den Patentansprüchen 1 bis 6 vorbeschriebenen Vorteile erreichen, wobei das erste Gehäuseelement ein oder mehrere in Verbindung mit diesen Patentansprüchen beschriebenen weitere Merkmale aufweisen kann.

Die Gehäuseelemente können vorzugsweise aus einem Spritzgussteil ausgeformt sein, wobei bevorzugt wird, dass wenigstens ein Gehäuseelement eine Wärmesenke ausformt. Dazu kann dieses Gehäuseelement vorzugsweise wenigstens teilweise, weiterhin bevorzugt vollständig aus Aluminium ausgebildet sein, wohingegen das keine Wärmesenkfunktion aufweisende Gehäuseelement vorzugsweise aus einem Kunststoff hergestellt ist. Eine elektrische Verbindung zwischen den in dem Gehäuse aufnehmbaren elektronischen Komponenten und weiteren außerhalb des Gehäuses angeordneten Komponenten kann in üblicher Weise beispielhaft über mit wenigstens einem Gehäuseelement ausgeformte Steckverbindungsmöglichkeit erfolgen. Das Gehäuse kann in seiner Form in bekannter Weise dem Einsatzort und/oder dem Einsatzzweck bedarfsgerecht ausgebildet sein. So kann das Gehäuse beispielsweise eine Form aufweisen, die geeignet ist, eine ein- oder zweiseitig bestückte Leiterplatte in dem Gehäuseinnenraum aufzunehmen. Weitere dem Fachmann bekannte Ausgestaltungen und Abwandlungen des Gehäuses unter Berücksichtigung der vorbeschriebenen bevorzugten Ausführungsformen sind vorstellbar.

Nach einem weiteren Aspekt der vorliegenden Erfindung wird ein Verfahren zum Herstellen eines Gehäuses für ein Steuergerät, insbesondere für ein Kfz-Steuergerät mit den Merkmalen nach dem Patentanspruch 11, vorzugsweise mit den Merkmalen nach einem der Patentansprüche 12 bis 14 vorgeschlagen. Dadurch kann wenigstens ein mit den Merkmalen nach einem der Patentansprüche 7 bis 10 ausgebildetes Gehäuse bereitgestellt werden. Weiter bevorzugt entspricht das erste Gehäuseelement einer vorbeschriebenen bevorzugten Ausführungsform eines Gehäuseelementes nach der vorliegenden Erfindung. Mit einem solch ausgebildeten Gehäuse können die vorerwähnten Vorteile erreicht werden.

Weitere Merkmale und Vorteile der Erfindung ergeben sich aus der nachfolgenden Beschreibung von einem bevorzugten Ausführungsbeispiel der Erfindung, anhand der Figuren der Zeichnung, die erfindungswesentliche Einzelheiten zeigen, und aus den Patentansprüchen. Die einzelnen Merkmale können je einzeln für sich oder zu mehreren in beliebiger Kombination bei einer bevorzugten Ausführungsvariante der Erfindung verwirklicht sein.

Ein bevorzugtes Ausführungsbeispiel der Erfindung wird nachfolgend anhand der beigefügten Zeichnung näher erläutert. Es zeigen:
- Fig. 1: eine schematische Draufsicht eines Gehäuses für ein Steuergerät gemäß einer bevorzugten Ausführungsform;
- Fig. 2: eine schematische Seitenansicht des in Fig. 1 gezeigten Gehäuses;
- Fig. 3: eine Schnittansicht entlang der in Fig. 2 gezeigten Schnittlinie III-III;
- Fig. 4A: eine vergrößerte Darstellung des in Fig. 3 gezeigten Ausschnitts IV;
- Fig. 4B: eine vergrößerte Schnittansicht des in Fig. 4A gezeigten Ausschnitts IV mit gebogenem Randabschnitt; und
- Fig. 5: ein Verfahrensschema zur Herstellung eines Gehäuses gemäß einer bevorzugten Ausführungsform.

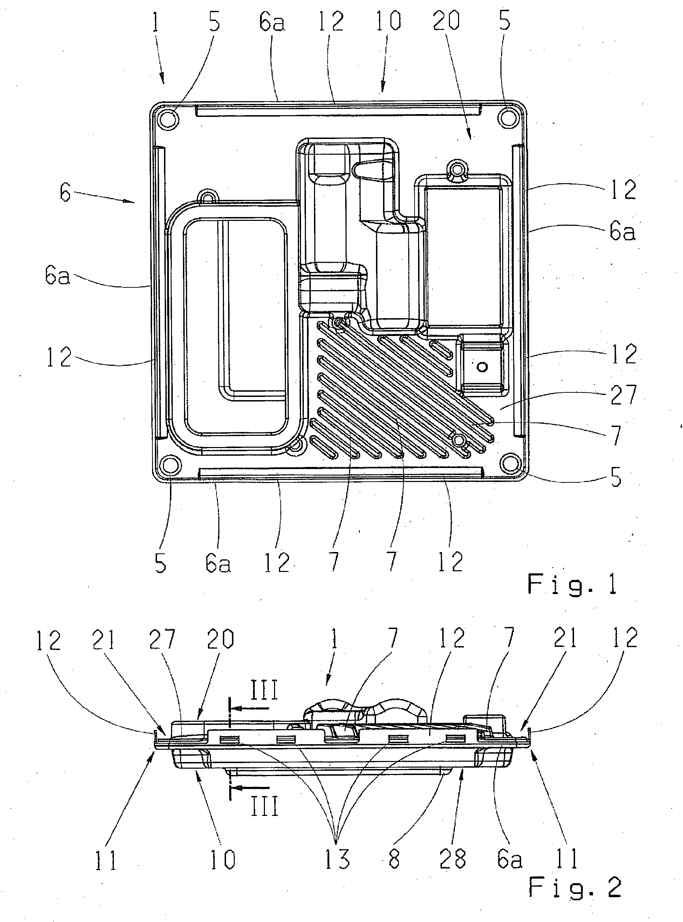

Fig. 1 zeigt eine schematische Draufsicht eines Gehäuses 1 für ein Steuergerät nach einer bevorzugten Ausführungsform. Das viereckige Steuergerätegehäuse 1 weist abgerundete Ecken auf und umfasst in jedem der Eckbereiche eine Durchgangsbohrung 5 zur Befestigung des Steuergerätegehäuses 1 beispielsweise in einem Motorraum eines Kraftfahrzeuges oder an einem Kfz-Getriebe. Die jeweiligen abgerundeten Eckbereiche mit den in Umfangsrichtung des Steuergerätes 1 daran anschließenden Randseiten 6a bilden einen das Steuergerätegehäuse 1 vollumfänglich umlaufenden Rand 6 aus. Die von dem Rand 6 eingefasste Oberseite 27 des Steuergerätegehäuses 1 weist eine Oberflächenstruktur auf, die im wesentlichen einer Kontur von in einem Gehäuseinnenraum 4 des Steuergerätegehäuses 1, auf einer Leiterplatte 3 angeordneten elektronischen Komponenten entspricht. Das Steuergerätegehäuse 1 ist aus einem Gussteil ausgeformt, wobei eine der Kontur der elektronischen Komponenten gerechte Oberflächenstruktur einfach und kostengünstig bereitgestellt werden kann.

Fig. 2 zeigt eine schematische Seitenansicht des in Fig. 1 gezeigten Steuergerätegehäuses 1. Das Steuergerätegehäuse 1 umfasst ferner ein einen Gehäuseboden ausformenden erstes Gehäuseelement 10 und ein einen Gehäusedeckel ausbildenden zweites Gehäuseelement 20. Die Gehäuseelemente 10, 20 sind aus einem Aluminium-Spritzgussteil ausgeformt, um eine von den elektronischen Komponenten erzeugte Wärme bedarfsgerecht abführen zu können. Dazu weist der Gehäusedeckel 20 in einem Bereich der Oberseite 27 mehrere zueinander parallel verlaufende Kühlrippen 7 auf. Der Gehäuseboden 10 bildet auf einer Unterseite 28 des Steuergerätegehäuses 1 eine Wärmesenke 8 zur Anlage mit einer Wärmeableitenden Komponente an einem Einsatz- bzw. Verwendungsort des Steuergerätegehäuses 1 aus.

Der Gehäusedeckel 20 umfasst in einem Randbereich des Steuergerätegehäuses 1 einen zweiten Randabschnitt 21, der eben ausgeformt und in Anlage mit einem eben ausgebildeten ersten Randabschnitt 11 des Gehäusebodens 10 ist. Der erste Randabschnitt 11 überragt den zweiten Randabschnitt 21 in einer eine Seitenrichtung des Steuergerätegehäuses 1 definierende Richtung, wobei sich an dem den zweiten Randabschnitt 21 seitlich überragenden Teilabschnitt unmittelbar ein biegbarer Randabschnitt 12 anschließt, der mit dem ersten Randabschnitt 11 aus einem Stück ausgeformt ist und von dem Gehäuseboden 10 vertikal zu der Unterseite 28 abragt. Querschnittlich ist der erste Randabschnitt 11 in dem Bereich des biegbaren Randabschnitts 12 L-förmig ausgebildet, wobei der mit den Fig. 1 und 2 gezeigte Montagezustand des Steuergerätegehäuses 1 keinen abschließend zusammengesetzten Zustand des Steuergerätegehäuses 1 zeigt.

Wie ferner in Fig. 2 gezeigt, sind entlang jeder Seitenkante des Steuergerätegehäuses 1 zwei biegbare Randabschnitte 12 mit identischer Ausgestaltung vorgesehen. Jeder biegbare Randabschnitt 12 umfasst zwei rechteckförmige Aussparungen 13.

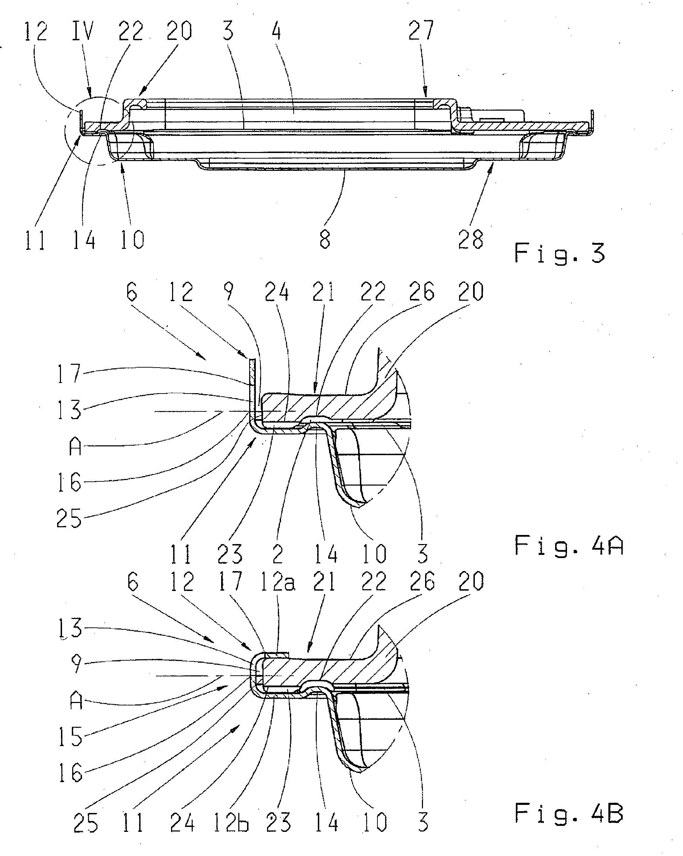

Fig. 3 zeigt eine Schnittansicht des Steuergerätegehäuses 1 entlang der in Fig. 2 gezeigten Schnittlinie III-III. Die Fig. 4A und 4B zeigen eine vergrößerte Darstellung des in Fig. 3 gezeigten Ausschnitts IV, wobei Fig. 4B im Besonderen den ersten Randabschnitt 11 in einem umgebogenen, an dem zweiten Randabschnitt 21 anliegenden und damit den zweiten Randabschnitt 21 einfassenden Zustand zeigt.

Im Einzelnen ist in den Fig. 3 und Fig. 4A gezeigt, dass der zweite Randabschnitt 21 des Gehäusedeckels 20 ein flaches stirnseitiges Ende 25 umfasst, dass dem biegbaren Randabschnitt 12 mit der Aussparung 13 beabstandet gegenüberliegt und zwischen dem biegbaren Randabschnitt 12 und dem stirnseitigen Ende 25 einen Zwischenraum 9 ausformt. Der zweite Randabschnitt 21 umfasst ferner auf der dem Gehäuseboden 10 zugewandten Oberflächenseite einen Zufuhrkanal 23, der sich von dem stirnseitigen Ende 25 bis zu einer mit dem Gehäusedeckel 20 ausgeformten und in Richtung des Gehäusebodens 10 zeigenden Dichtmittelaufnahmenut 22, in welcher ein mittels Luftfeuchtigkeit aushärtendes Dichtmittel 2 eingebracht ist, erstreckt. Der Zufuhrkanal 23 erstreckt sich in Erstreckungsrichtung der Randseite 6a mit einer Länge, die gleich oder größer einer parallel zu der Randseite 6a verlaufenden Erstreckungslänge der Aussparung 13 und kleiner oder gleich einer parallel dazu verlaufenden Erstreckungslänge des biegbaren Randabschnitts 12 ist. Dadurch kann zuverlässig beispielsweise eine über die Aussparung 13 zuführbare, das Steuergerätegehäuse 1 umgebende Umgebungsluft über den Zufuhrkanal 23 dem Dichtmittel 2 zugeführt werden, um eine gleichmäßige Aushärtung des Dichtmittels 2 zu gewährleisten. Des Weiteren kann einer Beschädigung des Dichtmittels 2 beispielsweise durch einen Hochdruckwasserstrahl wirksam begegnet werden, da sich der Zufuhrkanal 23 ausschließlich über von dem biegbaren Randabschnitt 12 überdeckte Bereiche erstreckt.

Der Gehäuseboden 10 umfasst im Bereich des ersten Randabschnitts 11 eine Erhebung 14, welche in die Dichtmittelaufnahmenut 22 hineinragt. Dadurch wird eine Anlagefläche für das Dichtmittel 2 erhöht, wodurch die Dichtfunktion des Steuergerätes 1 weiter verbessert werden kann.

Die in dem ersten Randabschnitt 11 angeordnete Aussparung 13 wird in Richtung zu der Erhebung 14 durch eine Unterkante 16 begrenzt, die vorteilhaft oberhalb einer den Zufuhrkanal 23 begrenzenden Zufuhrkanaloberkante 24 angeordnet ist. Dadurch kann ein direktes Richten eines Hochdruckwasserstrahls in den Zufuhrkanal 23 und damit ein ungehindertes Beaufschlagen des Dichtmittels 2 mit dem Hochdruckwasserstrahl bzw. mit einem hohen Druck weitestgehend verhindert werden. Vorzugsweise ist die Unterkante 16, wie in den Fig. 4A und 4B gezeigt, auf Höhe einer Mittelsenkrechten A des stirnseitigen Endes des zweiten Randabschnittes 21 vorgesehen.

Eine weitere in den Fig. 4A und 4B gezeigte Maßnahme zur Vermeidung der Direktbeaufschlagung des Dichtmittels 2 beispielsweise mit dem Hochdruckwasserstrahl ist ein Vorsehen des zwischen dem Gehäusedeckel 20 bzw. der Dichtmittelaufnahmenut 22 und dem Gehäuseboden 10 bzw. der Erhebung 14 gebildeten Dichtmittelaufnahmeraumes außerhalb eines einen in dem stirnseitigen Ende 25 des zweiten Randabschnitts 21 ausgeformten Zufuhrkanaleingang Bereiches. Im Einzelnen wird bei diesem bevorzugten Ausführungsbeispiel der Dichtmittelaufnahmeraum zwischen einem Boden der Dichtmittelaufnahmenut 22 und einem Gipfelanschnitt der Erhebung 14 ausgebildet. Des Weiteren erstreckt sich der Zufuhrkanaleingang an dem stirnseitigen Ende 25 von einer Oberflächenseite des ersten Randabschnitts 21 bis zu der Zufuhrkanaloberkante 24. Ein Erhebungsgrad der Erhebung 14 ist ferner derart gewählt, dass der Gipfelbereich der Erhebung 14 in Verlängerung der Zufuhrkanaloberkante 24 angeordnet ist.

In Richtung zu einem freien Ende des biegbaren Randabschnitts 12 wird die Aussparung von einer Oberkante 17 begrenzt, die derart ausgebildet ist, dass diese im gebogenen Zustand des biegbaren Randabschnitts 12, wie in Fig. 4B gezeigt, in einem Übergangsbereich zwischen dem stirnseitigen Ende 25 und einer äußeren Oberflächenseite 26 des zweiten Randabschnittes 21 zur Anlage kommt. So kann durch bloßes Biegen des biegbaren Randabschnitts 12 ein zwischen gegenüberliegende Seitenkanten des stirnseitigen Endes 25 verlaufender Radius ausgeformt werden, welcher gleichzeitig auf einer dem stirnseitigen Ende 25 zugewandte Innenseite des biegbaren Randabschnitts 12 den Zwischenraums 9 definiert. Ein sich an die Aussparung 13 angrenzender Abschnitt 12a des biegbaren Randabschnitts 12 liegt auf der äußeren Oberflächenseite 26 des zweiten Randabschnitts 21 auf. Vorzugsweise wird die Anlage unter einer Druckbeaufschlagung durchgeführt, um den Gehäusedeckel 20 mittels des ersten Randabschnitts 11 an dem zweiten Randabschnitt 21 klemmend einfassen zu können. Der erste Randabschnitt 11 ist im gebogenen Zustand U-förmig, wobei der auf der äußeren Oberflächenseite 26 des zweiten Randabschnitts 21 anliegende Abschnitt 12a einen oberen Schenkel und ein dem Zufuhrkanal 23 gegenüberliegender Abschnitt 12b des ersten Randabschnitt 11 einen unteren Schenkel und der zwischen den beiden Seitenkanten des stirnseitigen Endes 25 verlaufende, einen Randmittelabschnitt definierende Abschnitt 15 des ersten Randabschnitts 11 den Grund der U-Form ausmachen.

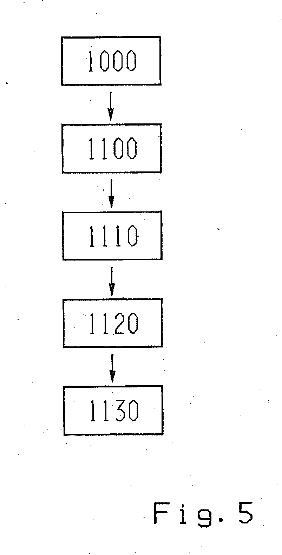

Fig. 5 zeigt ein Verfahrensschema zur Herstellung des mit den Fig. 1 bis 4B gezeigten Gehäuses. Grundsätzlich umfasst das Verfahren zur Herstellung eines Gehäuses für ein Steuergerät einen ersten Schritt 1000, mit welchem der Gehäuseboden 10 und der Gehäusedeckel 20 bereitgestellt werden, wobei der Gehäuseboden 10 wenigstens einen ersten Randabschnitt 11 mit wenigstens einer Aussparung 13 und der Gehäusedeckel 20 mit einem in Anlage mit dem wenigstens ersten Randabschnitt 11 verbringbaren zweiten Randabschnitt 21 aufweist. In einem zweiten Schritt 1100 werden der Gehäuseboden 10 und der Gehäusedeckel 20 unter Zwischenlage des mittels Luftfeuchtigkeit aushärtbaren Dichtmittels 2 zwischen den in Anlage zu verbringenden ersten 11 und diesem zugeordneten zweiten Randabschnitt 21 zusammengesetzt.

Zur Ausbildung des mit dem Fig. 1 bis 4B gezeigten bevorzugten Ausführungsbeispiels wird mit dem ersten Schritt 1000 des Weiteren ein Gehäuseboden 10 bereitgestellt, der wenigstens einen den zweiten Randabschnitt 21 überragenden biegbaren Randabschnitt 12 aufweist, wobei der biegbare Randabschnitt 12 einen Teilabschnitt des mit dem zweiten Randabschnitt 21 in Anlage zu verbringenden ersten Randabschnitts 11 ausbildet. Die Aussparung 13 ist in dem biegbaren Randabschnitt 12 angeordnet ist. Ferner wird mit dem ersten Schritt 1000 ein Gehäusedeckel 20 bereitgestellt, der zusätzlich mit einem von der wenigstens einen Aussparung 13 zu einem Anordnungsort des Dichtmittels 2 führenden Zufuhrkanal 23 für die Luftfeuchtigkeit umfasst. Der Anordnungsort des Dichtmittels 2 ist bei dem gezeigten Ausführungsbeispiel durch eine mit dem Gehäusedeckel 20 bereitgestellte Dichtmittelaufnahmenut 22 realisiert. Alternativ kann bei geeigneter Wandstärke des Gehäusebodens 10 die Dichtmittelaufnahmenut mit dem Gehäuseboden 10 bereitgestellt werden. Weiterhin alternativ kann die Dichtmittelaufnahmenut durch eine mit dem Gehäuseboden 10 und mit dem Gehäusedeckel 20 ausgeformte Ausnehmung ausgebildet werden, die zueinander gegenüberliegend im Anlagezustand des Gehäusebodens 10 mit dem Gehäusedeckel 20 angeordnet sind.

Der zweite Schritt 1100 umfasst nach Verbringen des ersten 10 mit dem zweiten Gehäuseelementes 20 in Anlage zueinander einen Teilschritt 1120, mit welchem der biegbare Randabschnitts 12 derart umgebogen wird, dass die wenigstens eine Aussparung 13 gegenüberliegend zu dem stirnseitigen Ende 25 des zweiten Randabschnittes 21 verbracht wird. Durch diesen Biegeschritt nimmt der erste Randabschnitt 11 eine L-Form ein. Alternativ dazu kann der Gehäuseboden 10 mit einem bereits solch vorgeformten biegbaren Randabschnitt 12 bereitgestellt werden.

In einem daran anschließenden weiteren Teilschritt 1130 wird der an die wenigstens eine Aussparung 13 angrenzende Abschnitt 12a des überstehenden biegbaren Randabschnitts 12 in Anlage mit der dem Dichtmittel 2 abgewandten äußeren Oberflächenseite 26 des zweiten Randabschnitts 21 verbracht.

Das mittels Luftfeuchtigkeit aushärtbare Dichtmittel 2, das beispielsweise ein Silikongummi sein kann, kann mit einem vor dem Teilschritt 1120 oder vor dem weiteren Teilschritt 1130 durchgeführten Zwischenschritt 1110 zwischen den Gehäuseboden 10 und dem Gehäusedeckel 20 eingebracht werden. Dazu können in dem ersten Schritt 1000 der Gehäuseboden 10 und/oder der Gehäusedeckel 20 mit wenigstens einem Dichtmittelzufuhrkanal oder mehreren Dichtmittelzufuhrkanälen bereitgestellt werden, über welchen bzw. welche das Dichtmittel 2 nach Verbringen der ersten 11 und zweiten Randabschnitte 21 in Anlage zueinander in flüssiger Form in die Zwischenlage zwischen Gehäuseboden 10 und Gehäusedeckel 20, insbesondere in die Dichtmittelaufnahmenut 22 zuführbar ist. Alternativ oder zusätzlich kann das Dichtmittel 2 über den Luftzufuhrkanal 23 zugeführt werden, der in dem ersten Schritt 1000 mit dem Gehäusedeckel 20 bereitstellbar ist.

### Bezugszeichen

- 1: Steuergerätegehäuse
- 2: Dichtmittel
- 3: Leiterplatte
- 4: Gehäuseinnenraum
- 5: Durchgangsbohrung
- 6: Rand
- 6a: Randseite
- 7: Kühlrippe
- 8: Wärmesenke
- 9: Zwischenraum
- 10: erstes Gehäuseelement
- 11: erster Randabschnitt
- 12: biegbarer Randabschnitt
- 12a: oberer Schenkel
- 12b: unterer Schenkel
- 13: Aussparung
- 14: Erhebung
- 15: Randmittelabschnitt
- 16: Unterkante der Aussparung
- 17: Oberkante der Aussparung
- 20: zweites Gehäuseelement
- 21: zweiter Randabschnitt
- 22: Dichtmittelaufnahmenut
- 23: Zufuhrkanal
- 24: Zufuhrkanaloberkante
- 25: stirnseitiges Ende des zweiten Randabschnitts
- 26: äußere Oberflächenseite des zweiten Randabschnitts
- 27: Oberseite des Steuergerätes
- 28: Unterseite des Steuergerätes
- 1000: erster Schritt
- 1100: zweiter Schritt
- 1110: Zwischenschritt
- 1120: Teilschritt
- 1130: weiterer Teilschritt
- A: Mittelsenkrechte

## Patentansprüche

1. Gehäuseelement (10) für ein Steuergerätegehäuse (1) umfassend einen oder mehrere erste Randabschnitte (11) zur Anlage jeweils mit einem zweiten Randabschnitt (21) eines dem Steuergerätegehäuse (1) zugeordneten zweiten Gehäuseelementes (20) unter Zwischenlage eines mittels Luftfeuchtigkeit aushärtbaren Dichtmittels (2); **dadurch gekennzeichnet, dass** wenigstens einer der ersten Randabschnitte (11) wenigstens eine Aussparung (13) zur Kommunikation des Dichtmittel (2) im Anlagezustand der Gehäuseelemente (10, 20) mit einer die Luftfeuchtigkeit enthaltenden Luft aufweist, wobei die Aussparung als offener Durchlass, der wenigstens zwei in verschiedene Richtungen zeigende Oberflächenseiten des Gehäuseelements (20) miteinander verbindet, ausgestaltet ist.

2. Gehäuseelement (10) nach Anspruch 1, **dadurch gekennzeichnet, dass** die wenigstens eine Aussparung (13) in einem anderen als einen zur Anlage mit dem Dichtmittel (2) bringbaren oder einen zur Aufnahme des Dichtmittels (2) geeigneten Bereich (14) des Gehäuseelementes (10) angeordnet ist.

3. Gehäuseelement (10) nach Anspruch 1 oder 2, **dadurch gekennzeichnet, dass** der wenigstens eine erste Randabschnitt (11) ein biegbarer Randabschnitt ist, der zum klemmenden Einfassen des zweiten Randabschnittes (21) U-förmig biegbar ist.

4. Gehäuseelement (10) nach Anspruch 3, **dadurch gekennzeichnet, dass** die wenigstens eine Aussparung (13) in einem im einfassenden Zustand den Grund der U-Form ausmachenden Randmittelabschnitt (15) angeordnet ist

5. Gehäuseelement (10) nach einem der Ansprüche 2 bis 4, **dadurch gekennzeichnet, dass** der erste Randabschnitt (11) derart biegbar ist, dass im einfassenden Zustand wenigstens ein dem Dichtmittelanlage- oder Dichtmittelaufnahmebereich (14) des Gehäuseelementes (10) naher Teilbereich der wenigstens einen Aussparung (13) beabstandet zu dem zweiten Randabschnitt (21) anordbar ist.

6. Gehäuseelement (10) nach Anspruch 4 und 5, **dadurch gekennzeichnet, dass** der Randmittelabschnitt (15) im Bereich der Aussparung (13) unter Ausbildung wenigstens eines Radius biegbar ist.

7. Gehäuse (1) für ein Steuergerät umfassend ein erstes (10) und ein zweites Gehäuseelement (20) zum Ausbilden eines zu einer Gehäuseaußenseite abgedichteten Gehäuseinnenraums (4) unter Zwischenlage eines mittels Luftfeuchtigkeit aushärtbaren Dichtmittels (2) zwischen miteinander kontaktierbare dem ersten Gehäuseelement (10) zugeordnete erste Randabschnitte (11) und dem zweiten Gehäuseelement (20) zugeordnete zweite Randabschnitte (21), **dadurch gekennzeichnet, dass** wenigstens einer der kontaktierbaren ersten (11) und zweiten Randabschnitte (21) wenigstens eine Aussparung (13) zur Kommunikation des Dichtmittels (2) mit einer die Luftfeuchtigkeit enthaltenden Luft aufweist, wobei die Aussparung als offener Durchlass, der wenigstens zwei in verschiedene Richtungen zeigende Oberflächenseiten des Gehäuseelements (20) miteinander verbindet, ausgestaltet ist.

8. Gehäuse (1) für ein Steuergerät nach Anspruch 7, **dadurch gekennzeichnet, dass** das erste Gehäuseelement (10) ein Gehäuseelement nach einem der Ansprüche 1 bis 6 ist.

9. Gehäuse (1) für ein Steuergerät nach Anspruch 8, **dadurch gekennzeichnet, dass** das zweite Gehäuseelement (20) eine Nut (22) zur Aufnahme des Dichtmittels (2) und einen Zufuhrkanal (23) zum Zuführen der über die wenigstens eine Aussparung (13) zuführbaren Luftfeuchtigkeit zu der Dichtmittelaufnahmenut (22) umfasst.

10. Gehäuse für ein Steuergerät nach Anspruch 9, **dadurch gekennzeichnet, dass** der Zufuhrkanal (23) angrenzend zu der wenigstens einen Aussparung (13) angeordnet ist.

11. Verfahren zum Herstellen eines Gehäuses (1) für ein Steuergerät, insbesondere nach Anspruch 7, **dadurch gekennzeichnet, dass** das Verfahren einen Schritt des Bereitstellens (1000) eines ersten Gehäuseelementes (10) mit wenigstens einem ersten Randabschnitt (11) aufweisend wenigstens eine Aussparung (13) und eines zweiten Gehäuseelementes (20) mit einem in Anlage mit dem wenigstens ersten Randabschnitt (11) verbringbaren zweiten Randabschnitt (21); und einen Schritt des Zusammensetzens (1100) der ersten (10) und zweiten Gehäuseelemente (20) unter Zwischenlage eines mittels Luftfeuchtigkeit aushärtbaren Dichtmittels (2) zwischen den in Anlage verbringbaren ersten (11) und diesem zugeordneten zweiten Randabschnitt (21) umfasst, wobei die Aussparung als offener Durchlass, der wenigstens zwei in verschiedene Richtungen zeigende Oberflächenseiten des Gehäuseelements (20) miteinander verbindet, ausgestaltet ist.

12. Verfahren nach Anspruch 11, **dadurch gekennzeichnet, dass** mit dem Schritt des Bereitstellens (1000) ein erstes Gehäuseelement (10) mit wenigstens einen den zweiten Randabschnitt (21) überragenden biegbaren Randabschnitt (12), der einen Teilabschnitt des mit dem zweiten Randabschnitt (21) in Anlage bringbaren ersten Randabschnitts (11) ausbildet, bereitgestellt wird, wobei die Aussparung (13) in dem biegbaren Randabschnitt (12) angeordnet ist; und dass der Schritt des Zusammensetzens (1100) nach Verbringen des ersten (10) mit dem zweiten Gehäuseelementes (20) in Anlage zueinander, der biegbare Randabschnitt (12) derart umgebogen wird, dass in einem Teilschritt (1120) die wenigstens eine Aussparung (13) gegenüberliegend zu einem stirnseitigen Ende (25) des zweiten Randabschnittes (21) und in einem weiteren Teilschritt (1130) ein an die wenigstens eine Aussparung (13) angrenzender Abschnitt (12a) des überstehenden biegbaren Randabschnitts (12) in Anlage mit einer dem Dichtmittel (2) abgewandten Oberflächenseite (26) des zweiten Randabschnitts (21) verbracht werden.

13. Verfahren nach Anspruch 11 oder 12, **dadurch gekennzeichnet, dass** mit dem Schritt des Bereitstellens (1000) ein zweites Gehäuseelemente (20) mit wenigstens einem von der wenigstens einen Aussparung (13) zu dem Dichtmittel (2) führenden Zufuhrkanal (23) für die Luftfeuchtigkeit bereitgestellt wird.

14. Verfahren nach Anspruch 13, **dadurch gekennzeichnet, dass** der Schritt des Zusammensetzens (1100) nach Verbringen des ersten (10) mit dem zweiten Gehäuseelementes (20) in Anlage zueinander einen Zwischenschritt (1110) des Zuführens eines flüssigen, mittels Luftfeuchtigkeit aushärtbaren Dichtmittels (2) über den Zufuhrkanal (23) in eine zwischen dem ersten (11) und dem zweiten Randabschnitt (21) ausgeformte Dichtmittelaufnahmenut (22) umfasst.

## Claims

1. Housing element (10) for a control device housing (1), comprising one or more first edge sections (11) for contact in each case with a second edge section (21) of a second housing element (20), which is assigned to the control device housing (1), with the interposition of a sealant (2) which is curable by means of air moisture, **characterized in that** at least one of the first edge sections (11) has at least one recess (13) in order, when the housing elements (10, 20) are in contact, for the sealant (2) to communicate with air containing the air moisture, wherein the recess is configured as an open passage which connects at least two surface sides, pointing in different directions, of the housing element (20) to each other.

2. Housing element (10) according to Claim 1, **characterized in that** the at least one recess (13) is arranged in a different region than a region (14) of the housing element (10) that can be brought into contact with the sealant (2) or is suitable for receiving the sealant (2).

3. Housing element (10) according to Claim 1 or 2, **characterized in that** the at least one first edge section (11) is a bendable edge section which is bendable in a U-shaped manner for the clamping enclosing of the second edge section (21).

4. Housing element (10) according to Claim 3, **characterized in that** the at least one recess (13) is arranged in an edge central section (15) which, in the enclosing state, forms the base of the U shape.

5. Housing element (10) according to one of Claims 2 to 4, **characterized in that** the first edge section (11) is bendable in such a manner that, in the enclosing state, at least one partial region of the at least one recess (13), which partial region is close to the sealant contact or sealant receiving region (14) of the housing element (10), is arrangeable at a distance from the second edge section (21).

6. Housing element (10) according to Claims 4 and 5, **characterized in that** the edge central section (15) is bendable in the region of the recess (13) with at least one radius being formed.

7. Housing (1) for a control device, comprising a first housing element (10) and a second housing element (20) for forming a housing interior (4), which is sealed with respect to an outer side of the housing, with the interposition of a sealant (2), which is curable by means of air moisture, between first edge sections (11), which are assigned to the first housing element (10), and second edge sections (21), which are assigned to the second housing element (20), which edge sections are contactable with each other, **characterized in that** at least one of the contactable first edge sections (11) and second edge sections (21) has at least one recess (13) in order for the sealant (2) to communicate with air containing the air moisture, wherein the recess is configured as an open passage which connects at least two surface sides, which point in different directions, of the housing element (20) to each other.

8. Housing (1) for a control device according to Claim 7, **characterized in that** the first housing element (10) is a housing element according to one of Claims 1 to 6.

9. Housing (1) for a control device according to Claim 8, **characterized in that** the second housing element (20) comprises a groove (22) for receiving the sealant (2) and a supply channel (23) for supplying the air moisture, which is suppliable via the at least one recess (13), to the sealant receiving groove (22).

10. Housing for a control device according to Claim 9, **characterized in that** the supply channel (23) is arranged adjacent to the at least one recess (13).

11. Method for producing a housing (1) for a control device, in particular according to Claim 7, **characterized in that** the method comprises a step of providing (1000) a first housing element (10) with at least one first edge section (11) having at least one recess (13) and a second housing element (20) with a second edge section (21) which is bringable into contact with the at least one first edge section (11); and a step of assembling (1100) the first housing element (10) and second housing element (20) with the interposition of a sealant (2), which is curable by means of air moisture, between the first edge section (11) and the second edge section (21) which is assigned to said first edge section (11), which edge sections are bringable into contact, wherein the recess is configured as an open passage which connects at least two surface sides, which point in different directions, of the housing element (20) to each other.

12. Method according to Claim 11, **characterized in that** with the providing step (1000), a first housing element (10) with at least one bendable edge section (12) which projects over the second edge section (21) and forms a partial section of the first edge section (11), which is bringable into contact with the second edge section (21), is provided, wherein the recess (13) is arranged in the bendable edge section (12), and wherein, with the assembling step (1100), after the first housing element (10) and the second housing element (20) are brought into contact with each other, the bendable edge section (12) is bent over in such a manner that, in a partial step (1120), the at least one recess (13) is brought so as to lie opposite an end-side end (25) of the second edge section (21), and, in a further partial step (1130), a section (12a) of the projecting, bendable edge section (12), which section (12a) is adjacent to the at least one recess (13), is brought into contact with a surface side (26) of the second edge section (21), which surface side faces away from the sealant (2).

13. Method according to Claim 11 or 12, **characterized in that**, with the providing step (1000), a second housing element (20) with at least one supply channel (23) for the air moisture, which supply channel leads from the at least one recess (13) to the sealant (2), is provided.

14. Method according to Claim 13, **characterized in that** the assembling step (1100), after the first housing element (10) and the second housing element (20) are brought into contact with each other, comprises an intermediate step (1110) of supplying a liquid sealant (2), which is curable by means of air moisture, via the supply channel (23) into a sealant receiving groove (22) formed between the first edge section (11) and the second edge section (21).

## Revendications

1. Elément de boîtier (10) pour un boîtier d'appareil de commande (1) comprenant une ou plusieurs premières sections de bord (11) destinées à venir en appui à chaque fois avec une deuxième section de bord (21) d'un deuxième élément de boîtier (20) associé au boîtier d'appareil de commande (1) en interposant un moyen d'étanchéité (2) durcissable au contact de l'humidité de l'air ; **caractérisé en ce qu'**au moins l'une des premières sections de bord (11) présente au moins un évidement (13) permettant la communication du moyen d'étanchéité (2) dans l'état d'appui des éléments de boîtier (10, 20) avec de l'air contenant l'humidité de l'air, l'évidement étant configuré sous forme de passage ouvert qui relie l'un à l'autre au moins deux côtés de surface de l'élément de boîtier (20) tournés dans des directions différentes.

2. Elément de boîtier (10) selon la revendication 1, **caractérisé en ce que** l'au moins un évidement (13) est disposé dans une région (14) de l'élément de boîtier (10) autre qu'une région pouvant être amenée en appui avec le moyen d'étanchéité (2) ou appropriée pour recevoir le moyen d'étanchéité (2).

3. Elément de boîtier (10) selon la revendication 1 ou 2, **caractérisé en ce que** l'au moins une première section de bord (11) est une section de bord flexible qui peut être fléchie en forme de U pour saisir par serrage la deuxième section de bord (21).

4. Elément de boîtier (10) selon la revendication 3, **caractérisé en ce que** l'au moins un évidement (13) est disposé dans une section centrale de bord (15) constituant la base de la forme en U dans l'état de serrage.

5. Elément de boîtier (10) selon l'une quelconque des revendications 2 à 4, **caractérisé en ce que** la première section de bord (11) est flexible de telle sorte que dans l'état de serrage, au moins une région partielle de l'au moins un évidement (13) proche de la région d'appui ou de réception du moyen d'étanchéité (14) de l'élément de boîtier (10) peut être disposée à distance de la deuxième section de bord (21).

6. Elément de boîtier (10) selon la revendication 4 et 5, **caractérisé en ce que** la section centrale de bord (15) peut être fléchie dans la région de l'évidement (13) en formant au moins un rayon.

7. Boîtier (1) pour un appareil de commande comprenant un premier (10) et un deuxième (20) élément de boîtier pour constituer un espace interne de boîtier (4) étanchéifié vis-à-vis d'un côté extérieur de boîtier en interposant un moyen d'étanchéité (2) durcissable au contact de l'humidité de l'air entre des premières sections de bord (11) associées au premier élément de boîtier (10) et des deuxièmes sections de bord (21) associées au deuxième élément de boîtier (20), les sections de bord pouvant être mises en contact les unes avec les autres, **caractérisé en ce qu'**au moins l'une des premières (11) et deuxièmes (21) sections de bord pouvant être mises en contact présente au moins un évidement (13) permettant la communication du moyen d'étanchéité (2) avec de l'air contenant l'humidité de l'air, l'évidement étant configuré sous forme de passage ouvert qui relie l'un à l'autre au moins deux côtés de surface de l'élément de boîtier (20) tournés dans des directions différentes.

8. Boîtier (1) pour un appareil de commande selon la revendication 7, **caractérisé en ce que** le premier élément de boîtier (10) est un élément de boîtier selon l'une quelconque des revendications 1 à 6.

9. Boîtier (1) pour un appareil de commande selon la revendication 8, **caractérisé en ce que** le deuxième élément de boîtier (20) comprend une rainure (22) pour recevoir le moyen d'étanchéité (2) et un canal d'alimentation (23) pour alimenter l'humidité de l'air pouvant être alimentée par le biais de l'au moins un évidement (13) à la rainure de réception du moyen d'étanchéité (22).

10. Boîtier pour un appareil de commande selon la revendication 9, **caractérisé en ce que** le canal d'alimentation (23) est disposé en position adjacente à l'au moins un évidement (13).

11. Procédé de fabrication d'un boîtier (1) pour un appareil de commande, en particulier selon la revendication 7, **caractérisé en ce que** le procédé comprend une étape de fourniture (1000) d'un premier élément de boîtier (10) avec au moins une première section de bord (11) présentant au moins un évidement (13) et d'un deuxième élément de boîtier (20) avec une deuxième section de bord (21) pouvant être amenée en appui avec l'au moins une première section de bord (11) ; et une étape d'assemblage (1100) des premier (10) et deuxième (20) éléments de boîtier en interposant un moyen d'étanchéité (2) durcissable au contact de l'humidité de l'air entre la première section de bord (11) pouvant être amenée en appui et la deuxième section de bord (21) associée à celle-ci, l'évidement étant configuré sous forme de passage ouvert qui relie l'un à l'autre au moins deux côtés de surface de l'élément de boîtier (20) tournés dans des directions différentes.

12. Procédé selon la revendication 11, **caractérisé en ce qu'**avec l'étape de fourniture (1000) est fourni un premier élément de boîtier (10) avec au moins une section de bord flexible (12) faisant saillie au-delà de la deuxième section de bord (21), qui constitue une section partielle de la première section de bord (11) pouvant être amenée en appui avec la deuxième section de bord (21), l'évidement (13) étant disposé dans la section de bord flexible (12) ; et avec l'étape d'assemblage (1100) après la mise en appui l'un contre l'autre du premier (10) et du deuxième (20) élément de boîtier, la section de bord flexible (12) est repliée de telle sorte que dans une étape partielle (1120), l'au moins un évidement (13) soit amené en regard d'une extrémité frontale (25) de la deuxième section de bord (21) et que dans une autre étape partielle (1130), une section (12a) adjacente à l'au moins un évidement (13) de la section de bord flexible saillante (12) soit amenée en appui avec un côté de surface (26) de la deuxième section de bord (21) opposé au moyen d'étanchéité (2).

13. Procédé selon la revendication 11 ou 12, **caractérisé en ce qu'**avec l'étape de fourniture (1000), un deuxième élément de boîtier (20) est fourni avec au moins un canal d'alimentation (23) pour l'humidité de l'air conduisant depuis l'au moins un évidement (13) jusqu'au moyen d'étanchéité (2).

14. Procédé selon la revendication 13, **caractérisé en ce que** l'étape d'assemblage (1100) après la mise en appui l'un contre l'autre du premier élément de boîtier (10) et du deuxième élément de boîtier (20) comprend une étape intermédiaire (1110) d'alimentation d'un moyen d'étanchéité liquide (2) durcissable au contact de l'humidité de l'air par le biais du canal d'alimentation (23) dans une rainure de réception de moyen d'étanchéité (22) formée entre la première (11) et la deuxième (21) section de bord.
